# EUROPEAN PATENT APPLICATION

(11) **EP 1 257 065 A1**
(43) Date of publication of application: **13.11.2002**
(21) Application number: 01111428.7
(22) Date of filing: 10.05.2001
(51) Int. Cl.: H04B 1/40

(54) **Frequency synthesiser for mobile terminals for wireless telecommunication systems**

(71) Applicant: Sony International (Europe) GmbH, 10785 Berlin (DE)
(72) Inventor: Camuffo, Andrea, c/o Sony Int. (Europe) GmbH, 85609 Aschheim (DE)
(74) Representative: Körber, Martin, Dipl.-Phys.

(57) **Abstract**

The present invention relates to a frequency synthesiser (1) for providing receiving and transmitting frequencies in the wireless telecommunication systems GSM, DCS and W-CDMA, running in transmitting and receiving modes, both modes providing respectively three frequency ranges to be used in a transceiving means of a mobile terminal for at least one of the three wireless telecommunication systems, comprising a first and a second oscillating means (2, 3) for generating a first and a second frequency, a first shifting means (4) and a second shifting means (5) for generating the transmitting and receiving frequencies.

## Description

The present invention relates to a frequency synthesiser for providing receiving and transmitting frequencies, which are necessary for running mobile terminals in the wireless telecommunication systems W-CDMA (Wide-Code Multiple Access), GSM (Global System for Mobile Telecommunication) and DCS (Digital Cellular Telecommunication System).

Since the above-mentioned telecommunication systems work over air-interfaces in different frequency ranges, the frequency ranges for the respective telecommunication system have to be generated for modulating and demodulating signals, which have to be transmitted and received according to these standards.

The specific frequency ranges are: 925 to 960 MHz for GSM, 1805 to 1880 MHz for DCS and 2110 to 2170 MHz for W-CDMA in the receiving mode and 880 to 915 MHz for GSM, 1710 to 1785 MHz for DCS and 1920 to 1980 MHz for W-CDMA in the transmitting mode. It is noted, that the frequency range named above for GSM specifies the frequency range for EGSM (extended GSM).

In the prior art transceivers are known, which are capable to transmit/receive signals in the GSM-System and also for satellite networks. However, this transceiver demodulates the received signals into an intermediate frequency band before demodulating the signals into the baseband. This has the disadvantage, that a relatively high quantity of electronic devices is necessary, which increases the required space, the power consumption and the cost.

Further, in the prior art frequency synthesisers are known to provide all necessary frequency ranges for mobile terminals, which are operating in GSM, DCS as well as in W-CDMA telecommunication systems. These known devices however have a complex circuitry and are thus costly and large.

It is therefore the object of the present invention to provide a frequency synthesiser, which provides all above-mentioned frequency ranges and which is realised with a minimum quantity of electronic parts.

This object is achieved by a frequency synthesiser for providing, receiving and transmitting frequencies in the wireless telecommunication systems GSM, DCS and W-CDMA according to claim 1.

According to the present invention, the necessary frequencies, which are needed for a triple band (GSM, DCS, W-CDMA), dual mode (receiving and transmitting) integrated transceiver for use in a mobile terminal for at least one of the three wireless telecommunication systems, are generated by suitable mixing and shifting, respectively, and dividing of only two reference frequencies generated by only two oscillating means.

Therefore, the frequency synthesiser for providing receiving and transmitting frequencies in the wireless telecommunication systems GSM, DCS and W-CDMA, running in transmitting and receiving modes, both modes providing respectively three frequency ranges to be used in a transceiving means of a mobile terminal for at least one of the three wireless telecommunication systems comprises just two oscillating means for generating frequencies, whereby a first oscillating means generates a first frequency and a second oscillating means generates a second frequency.

The frequency synthesiser further comprises a first shifting means for generating frequency ranges in receiving modes on the basis of the first frequency shifted by a frequency, which is derived from the second frequency, and second shifting means for generating frequency ranges in transmitting mode on the basis of the first frequency shifted by a frequency, which is derived from the second frequency.

The advantage of the use of exact two oscillating means is, that the frequency synthesiser according to the present invention can be used with direct conversion receivers, since the problem of DC-offset, which occurs in direct conversion receivers, when using oscillators running at the same frequency as the carrier of the received signal, will be reduced by generating a frequency, which is generated from two different oscillating means.

Advantageously, for generating frequencies in different frequency ranges, the first oscillating means generates a first frequency, which is variable and a second oscillating means generates a second frequency, which is fix.

Advantageously, the first and second frequencies are relatively high, which leads to a better noise performance of the oscillating means, in opposite to lower frequencies. Further, the frequency range of the variable first frequency is relatively narrow, which leads to short times to switch between different frequencies. Thus, the first oscillating means generates advantageously frequencies in the range of 1995 to 2170 MHz and the second oscillating means generates a frequency of 3040 MHz.

In the receiving mode the frequency range for W-CDMA is directly derived from the first frequency, the frequency range for GSM is generated from the first frequency shifted by a frequency, which is derived from a second frequency, and then divided by two, and the frequency range for DCS is generated from first frequency shifted by a frequency, which is derived from the second frequency.

In the transmitting mode, the frequency ranges for GSM, DCS and W-CDMA are generated on the basis of the first frequency shifted by a frequency, which is derived from the second frequency.

The frequency synthesiser further comprises a first dividing means for dividing the first frequency by m (m being a positive integer) in the transmitting mode, whereby the divided frequency is shifted by the frequency, which is derived from the second frequency.

Advantageously, the values for m are m=4 for GSM and m=1 for DCS and W-CDMA.

In the receiving mode the frequency, which is derived from the second frequency, is equal to the second frequency divided by 16, and in the transmitting mode the frequency, which is derived from the second frequency, is equal to the second frequency divided by 16 for W-CDMA and equal to the second frequency divided by 8 for GSM and DCS.

Advantageously, the first shifting means is realised by an image reject mixer. An image reject mixer rejects one side band of a frequency, which is generated by modulating one frequency by another frequency.

The second shifting means is realised by a phase locked loop. This has the advantage, that the generated signal is of a high quality and is pre-amplified, so that the specifications for the power amplifier, which is needed for transmitting the modulated signal, can be reduced.

The frequency synthesiser further comprises a modulating means for modulating a frequency, which is derived from the second oscillating means, by an input signal in the transmitting mode.

In the following description, a preferred embodiment of the present invention is explained in more detail with reference to the enclosed drawing, in which

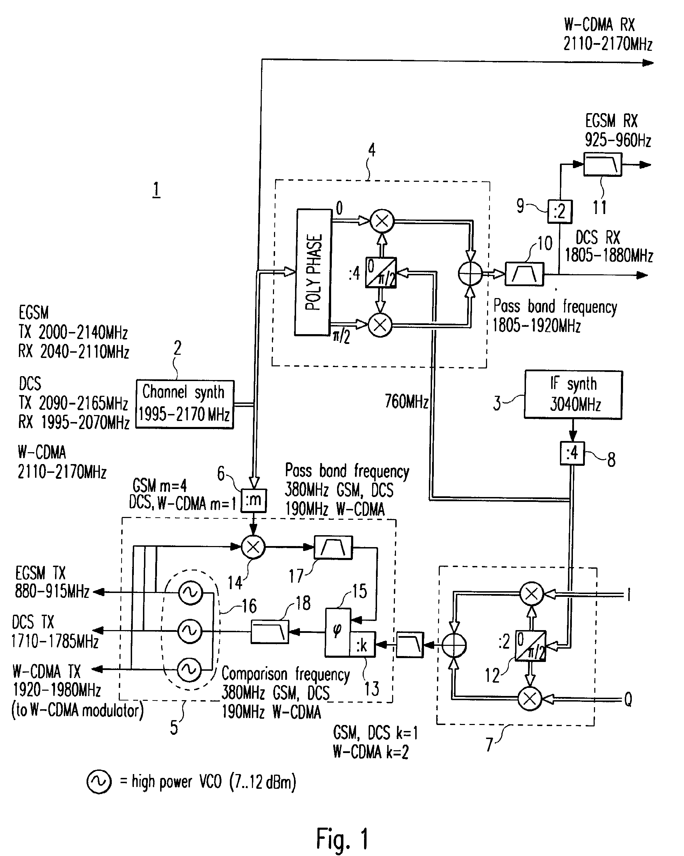

Fig. 1 shows a block diagram of an electronic circuit comprised in a frequency synthesiser according to the present invention.

The frequency synthesiser 1 according to the present invention comprises just two oscillating means, namely the first oscillating means 2 and the second oscillating means 3. The oscillating means 2, 3 are in the shown example realised by phase locked loops, which use quartz oscillators as reference.

In the shown embodiment of the present invention, the first oscillating means 2 has a frequency which is variable in the frequency range from 1995 to 2170 MHz, the second oscillating means 3 has a fix frequency of 3040 MHz; the frequency of the second oscillating means 3 is divided by 4 by a second dividing means 8, which leads to a frequency of 760 MHz.

When operating in the receiving mode, the frequency synthesiser 1 provides the frequency ranges 925 to 960 MHz for EGSM, 1805 to 1880 MHz for DCS and 2110 to 2170 MHz for W-CDMA.

The frequency ranges for receiving signals (receiving mode), which are generated by the frequency synthesiser 1 according to the present invention, are suitable for receivers, which convert the received signals directly into the base bands without converting these signals into an intermediate band ( so called direct conversion receiver, DCR).

The frequency range for EGSM is generated by shifting the frequency of the first oscillating means 2, which operates in a frequency range of 2040 to 2110 MHz in receiving-(RX-)mode for EGSM, and is shifted by a frequency, which is derived from the second frequency. The derived frequency in the receiving mode in this embodiment of the present invention arises from the second frequency (3040 MHz) divided by four by the second dividing means 8 (→ 760 MHz) and then divided by four by the first shifting means 4, which results to a frequency of 190 MHz.

The frequency range of 2040 to 2110 MHz shifted by 190 MHz by the first shifting means 4 results to a frequency range from 1850 to 1980 MHz. This frequency range is divided by two by a third dividing means 9, which results to the EGSM frequency range of 925 to 960 MHz for the receiving mode.

For providing the DCS-frequency range of 1805 to 1880 MHz, in the receiving mode the first oscillating means 2 provides a frequency range of 1995 to 2070 MHz. This (first) frequency is likewise shifted by 190 MHz, which is derived from the second frequency as explained above and leads to a frequency range of 1805 to 1880 MHz suitable for receiving DCS-signals.

The characteristic on generating the receiving frequencies for EGSM and DCS is, that these frequencies are generated by using the same shifting means 4.

To minimise unwanted effects like image frequencies, noise, etc., the first shifting means 4 is realised by an image reject type of mixer. The characteristic of this mixer is, that it is only one side band (a single side band) of the mixed frequency output. Further, the output signal output by the shifting means 4 is filtered by a first filter 10 which is a band pass filter, with the frequency range from 1805 to 1920 MHz. The output signal for EGSM can be additionally filtered by a second filter 11, which is a low pass filter.

In the receiving mode, the frequency mode for W-CDMA signal (2110 to 2170 MHz) is directly derived from the first oscillating means 2.

Since the spectrum of a W-CDMA signal has a broad frequency range, it is possible to eliminate the unwanted DC-offset by suitable high pass filtering after the demodulation. Therefore, it is possible to generate the RX-signal directly by only using the first oscillating means 2.

Thus, the frequencies of the signals in receiving mode follow from the formulas (LO1-(LO2/16))/2 for GSM, LO1-(LO2/16) for DCS and LO1 for W-CDMA, LO1 being the frequency of the first oscillating means 2 and LO2 being the frequency of the second oscillator means 3.

In the following description, the generation of the respective frequency ranges in the transmitting (TX) mode of the frequency synthesiser is described.

The frequency ranges for transmitting are generated by dividing the first frequency by m, whereby m is dependent on the respective wireless telecommunication system (m=4 for GSM, m=1 for DCS and W-CDMA), and by shifting the divided frequency by a frequency, which is derived from a second frequency. This derived frequency results from the second frequency by dividing, whereby the dividing factor is dependent on the respective communication system.

The divided frequency, which emerges from the second frequency, is first divided by 4 by the second dividing means 8, then divided by 2 by a fourth dividing means 12. After modulating by the modulating means 7 (which is described later), this signal is again divided by a factor k, whereby k is also dependent on the respective wireless communication system; k= 1 for GSM and DCS, k=2 for W-CDMA.

The first divided frequency and a second divided frequency are input to the second shifting means 5. The second shifting means comprises a frequency mixer 14, a phase comperator 15, and voltage controlled oscillators 16 (VCO). Further, the second shifting means comprises a second band pass filter 17 and a second low pass filter 18.

To generate the output signals (frequencies) in the transmitting mode (TX), the frequency generated by the respective VCO 16 is mixed with the first frequency divided by m. After filtering by the second band pass filter 17, the resulting signal is input to a phase comperator 15. The signal, which is derived from the second oscillating means 3 and at last divided by the factor k is also input to the phase comperator 15.

The object of the phase comperator 15 is to regulate the respective VCO 16 in such a way, that the both frequencies, which are input to the phase comperator 15, are equal. That means, that depending on the wireless communication system the input frequencies of the phase comperator 15 are either 190 MHz or 380 MHz.

Thus, the output frequencies in transmission mode emerge from the formulas (LO1/4)+(LO2/8) for GSM, LO1-(LO2/8) for DCS and LO1-(LO2/16) for W-CDMA.

Additionally, the output signals can be modulated by an input signal I and Q which contains the information (e.g. like speech) to be transmitted. Therefore, the frequency, which is derived from the second oscillating means 3 and then divided by the fourth dividing means 12, is modulated by the I and Q-Signals by the modulating means 7 and then output to the fifth dividing means 13. The modulating means can e.g. be an image reject mixer like the first shifting means 4.

Since the power of the modulation envelope is not constant at the W-CDMA system, the modulation for this transmission system will advantageously take place after the frequency synthesiser according to the present invention. Therefore, in this case the I and Q signals are mute and carry only an appropriate DC bias voltage.

The frequency synthesiser according to the present invention is advantageously used in mobile terminals for providing all necessary frequencies for transmitting and receiving signals in the (E)GSM, DCS and W-CDMA communication system.

## Claims

1. Frequency synthesiser (1) for providing receiving and transmitting frequencies in the wireless telecommunication systems GSM, DCS and W-CDMA, running in transmitting and receiving mode, both modes providing respectively three frequency ranges to be used in a transceiving means of a mobile terminal for at least one of said three wireless telecommunication systems, comprising
just two oscillating means for generating frequencies, whereby a first oscillating means (2) generates a first frequency and a second oscillating means (3) generates a second frequency,
a first shifting means (4) for generating frequency ranges in receiving mode on the basis of the first frequency shifted by a frequency, which is derived from the second frequency, and
a second shifting means (5) for generating frequency ranges in transmitting mode on the basis of the first frequency shifted by a frequency, which is derived from the second frequency.

2. Frequency synthesiser (1) according to claim 1,
**characterised in**
**that** the first frequency is variable and the second frequency is fix.

3. Frequency synthesiser (1) according to claim 1 or 2,
**characterised in**
**that** the first frequency is variable in the range from 1995 MHz to 2170 MHz and the second frequency is 3040 MHz.

4. Frequency synthesiser (1) according to claim 1, 2 or 3,
**characterised in**
**that** in the receiving mode the frequency range for W-CDMA is directly derived from the first frequency, the frequency range for GSM is generated from the first frequency shifted by a frequency, which is derived from the second frequency, and then divided by two and the frequency range for DCS is generated from the first frequency shifted by a frequency, which is derived from the second frequency, and
in the transmitting mode the frequency ranges for GSM, DCS and W-CDMA are generated on the basis of the first frequency shifted by a frequency, which is derived from the second frequency.

5. Frequency synthesiser (1) according to one of the claims 1 to 4,
**characterised by**
a first dividing means (6) for dividing the first frequency by m in transmitting mode,
whereby the divided frequency is shifted by the frequency, which is derived from the second frequency.

6. Frequency synthesiser (1) according to claim 5,
**characterised in**
**that** m=4 for GSM and m=1 for DCS and W-CDMA.

7. Frequency synthesiser (1) according to one of the claims 1 to 6,
**characterised in**
**that** in the receiving mode the frequency, which is derived from the second frequency, is equal to the second frequency divided by 16, and
in the transmitting mode the frequency, which is derived from the second frequency, is equal to the second frequency divided by 16 for W-CDMA and equal to the second frequency divided by 8 for GSM and DCS.

8. Frequency synthesiser (1) according to one of the claims 1 to 7,
**characterised in**
**that** the first shifting means (4) is realized by an image reject mixer.

9. Frequency synthesiser (1) according to one of the claims 1 to 8,
**characterised in**
**that** the second shifting means (5) is realized by a phase locked loop.

10. Frequency synthesiser (1) according to one of the claims 1 to 9,
**characterised by**
a modulating means (7) for modulating a frequency, which is derived from the second oscillating means (3), by an input signal in the transmitting mode.
